Europäisches Patentamt

European Patent Office

Office européen des brevets

(11) Veröffentlichungsnummer: **0 443 170 A2**

# (12) EUROPÄISCHE PATENTANMELDUNG

(21) Anmeldenummer: 90124727.0

(22) Anmeldetag: 19.12.90

(51) Int. Cl.5: **H04B 1/10**, H04B 1/16

(30) Priorität: 20.02.90 DE 4005272

(43) Veröffentlichungstag der Anmeldung:
28.08.91 Patentblatt 91/35

(84) Benannte Vertragsstaaten:
CH DE FR IT LI

(71) Anmelder: **ROBERT BOSCH GmbH**
**Postfach 10 60 50**
**W-7000 Stuttgart 10(DE)**

(72) Erfinder: **Braegas, Peter, Dipl.-Ing.**
**Hausbergring 49**
**W-3200 Hildesheim(DE)**

(54) Verfahren zur ZF-Bandbreitenumschaltung sowie ZF-Bandbreitenumschaltvorrichtung.

(57) Es wird ein Verfahren zur ZF-Bandbreitenumschaltung sowie eine ZF-Bandbreitenumschaltung in einem AM-Rundfunkempfänger beschrieben beschrieben.

Eine solche Umschaltung ist zweckmäßig, wenn neben Rundfunksendern mit normaler Modulationsbandbreite auch solche mit vergrößerter Bandbreite Programme ausstrahlen. Um einen optimalen Empfang zu erhalten wird die Umschaltung in Abhängigkeit der Empfangsverhältnisse durchgeführt. Dazu lassen sich die Fehlerrate einer AM-Zusatzinformation, die Nachbarkanalstörungen und die Empfangsfeldstärke auswerten. Diese Kriterien können sowohl für sich als auch in unterschiedlicher Kombination verwendet werden.

Die Erfindung betrifft ein Verfahren zur ZF-Bandbreitenumschaltung nach den Oberbegriffen der Ansprüche 1, 2, 3 und 8.

Qualitativ hochwertiger Ton-Rundfunkempfang ist im europäischen Raum bislang nur über die UKW-Sender möglich. Im Mittelwellenbereich hingegen herrscht aufgrund der durch das Kanalraster von 9 kHz begrenzten NF-Bandbreite von 4,5 kHz eine geringe Klangqualität.

Die Mittelwellen-Sender wurden, von einigen Ausnahmen abgesehen, bisher zur überregionalen Versorgung von solchen Gebieten eingesetzt, die außerhalb der Reichweite der UKW-Sender liegen. Das auf Mittelwelle ausgestrahle Programm wurde aber auch über die UKW-Sender abgestrahlt.

Zur Vergrößerung des Programmangebots wird von H. Fritsch "Mittelwelle, Akzeptanz durch mehr Klang", Funkschau 1990, Heft 3, Seiten 40 - 45 vorgeschlagen, auch auf der Mittelwelle "eigene" Programme auszustrahlen. Dabei ist geplant, eine größere NF-Bandbreite bei der Ausstrahlung zu verwenden, als dies bisher der Fall ist. Durch Versuche soll herausgefunden werden, bei welchen Sendern und Frequenzen sowie zu welchen Tageszeiten dies ohne Störungen benachbarter Sender möglich ist.

Wird nach Abschluß dieser Versuche von einzelnen Sendern ein breitbandiges Programm ausgestrahlt, so wird es künftig zweierlei Arten von Sendern auf dem Mittelwellen- und eventuell auch auf dem Langwellenbereich geben. Die einen Sender arbeiten wie bisher mit normaler Bandbreite, die sich in das übliche 9 kHz-Raster einfügt und die anderen Sender mit einer Bandbreitenerweiterung auf vorzugsweise 7 kHz NF-Bandbreite.

Umd die Programme in der jeweils angebotenen Qualität empfangen zu können, muß von dem bisherigen Empfängerkonzept mit einer festen ZF-Bandbreite abgewichen werden. Vielmehr Ist eine Umschaltmöglichkeit des ZF-Filters zu schaffen, um jeweils optimale Empfangsergebnisse zu erzielen.

Eine an sich denkbare manuelle Umschaltmöglichkeit ist unkomfortabel, da aufgrund der wechselnden Ausbreitungsbedingungen der Mittelwelle Schwankungen der Empfangsqualität auftreten können, die beim Empfang von Sendern mit vergrößerter Bandbreite auch in der laufenden Sendung eine Umschaltung des ZF-Filters auf eine schmalere Bandbreite erforderlich machen können. Dies ist besonders bei Fahrzeugempfängern zu erwarten, wenn sich die Entfernung vom Senderstandort vergrößert.

Der Erfindung liegt die Aufgabe zugrunde, ein Verfahren zur ZF-Bandbreitenumschaltung in einem AM-Rundfunkempfänger zu schaffen, welches eine vom Programmangebot und den Empfangsverhältnissen abhängige automatische Umschaltung der ZF-Bandbreite ermöglicht.

Diese Aufgabe wird bei einem Verfahren gemäß den Oberbegriffen der nebengeordneten Ansprüche 1, 2, 3 und 8 durch die im jeweiligen Kennzeichen angegebenen Merkmale gelöst.

Im Falle der Ansprüche 1, 2 und 3 wird davon ausgegangen, daß im Zuge der Senderumstellung zusammen mit dem Rundfunkprogramm eine AM-Zusatzinformation ausgesendet wird, die unter anderem auch eine Modulationsbandbreiten-Kennung enthalten kann. Die Auswertung dieser Kennung würde sich dann anbieten, eine Umschaltung der ZF-Bandbreite vorzunehmen.

Dieses Kriterium berücksichtigt aber nicht die unterschiedlichen Empfangsbedingungen, denen ein Empfänger ausgesetzt ist. Die Überlegung der Erfindung beruht deshalb darauf, zusätzlich zu einer solchen Modulationsbandbreitenkennung Kriterien auszuwerten, die ein Maß für die Empfangsqualität darstellen.

Eine erste Möglichkeit besteht darin, die Fehlerrate der AM-Zusatzinformation auszuwerten.

Störungen in Form von Rauschen, Prasseln oder benachbarter Sender verfälschen nämlich die AM-Zusatzinformation etwa in dem Maße wie sie auch die Ton-Modulation beeinflussen. Daher stellt die Auswertung der Fehlerrate eine Möglichkeit dar, ein meßtechnisches Kriterium dafür zu bilden, wann ein umschaltbares ZF-Filter von "breit" auf "schmal" oder umgekehrt geschaltet werden muß.

Der Schwellwert für die Fehlerrate, bei der eine Umschaltung erfolgt, kann durch Versuche ermittelt werden und hängt auch von der Gesamtkonzeption einer Empfangsanlage, also dem Zusammenwirken von Empfänger und Antenne ab. Unter großer Fehlerrate wird eine Fehlerrate verstanden, die oberhalb des empirisch festzulegenden Schwellwertes liegt, eine kleine Fehlerrate ist eine solche, die unterhalb dieses Schwellwertes liegt.

Weiterhin wird unter einer breiten ZF-Bandbreite eine solche Bandbreite verstanden, die die Wiedergabe des gesamten Spektrums der bandbreitenerhöhten Sendung ermöglicht. Die schmale ZF-Bandbreite hingegen ist die bisher übliche Bandbreite, welche auf das Kanalraster, in Europa also 9 kHz, angepaßt ist.

Eine zweite Alternative sieht vor, daß zusätzlich zur Modulationsbandbreiten-Kennung der AM-Zusatzinformation ein Nachbarkanal-Störsignal ausgewertet wird. Ein solches Signal kommt zustande, wenn im Nachbarkanal des empfangenen Senders ein weiterer starker Sender zu empfangen ist. Durch die überlagerung der beiden Trägerfrequenzen ergibt sich nämlich eine Differenzfrequenz in Höhe des Rasterabstandes, deren Amplitude ebenfalls ein Maß für die störende Beeinflussung des benachbarten Senders darstellt und sich ebenfalls zur Veranlassung der Bandbreitenumschaltung verwerten läßt.

Die Hörbarkeit dieses Überlagerungstons ist zwar durch den Einsatz von Sperrfiltern im Empfänger beseitigt, es ergibt sich jedoch eine Störung durch die überlagerung der Modulations-Seitenbänder, welche in der breiten Einstellung des ZF-Filters hörbare Störungen hervorrufen würde. Geringe und große Nachbarkanalstörungen beziehen sich wieder auf eine empirisch festzulegende Schwelle, bei welcher die Umschaltung des ZF-Filters von breit auf schmal und umgekehrt erfolgen soll.

Eine dritte Alternative für die Beurteilung der Empfangsverhältnisse bildet die Messung der Empfangsfeldstärke. Neben möglichen Rausch- und Prasselstörungen nimmt auch das Durchschlagen benachbarter Sender zu, wenn relativ zu diesen die Empfangsfeldstärke des eingestellten Senders nachläßt. Analog wie bei den vorerwähnten Alternativen bezieht sich hohe Empfangsfeldstärke und kleine Empfangsfeldstärke wiederum auf eine Schwelle, bei der eine Umschaltung des ZF-Filters vorgenommen werden soll. Hohe Empfangsfeldstärke beinhaltet also alle Empfangsfeldstärkenwerte, die oberhalb dieser empirisch festzulegenden Schwelle liegen, kleine Empfangsfeldstärke sind alle Empfangsfeldstärkewerte, die unterhalb der Schwelle liegen.

Während es prinzipiell möglich ist, eines der vorgenannten Kriterien ausschließlich zu verwenden, besteht auch die Möglichkeit, eine Kombination zweier oder aller Kriterien durchzuführen. Denkbar ist dabei, die Fehlerrate zusammen mit der Nachbarkanalstörung auszuwerten, die Nachbarkanalstörung zusammen mit der Empfangsfeldstärke auszuwerten oder die Empfangsfeldstärke zusammen mit der Fehlerrate zu berücksichtigen. Dabei ist sowohl eine kombinatorische als auch eine alternative Auswertung möglich.

Neben der Kombination von zwei Kriterien können auch die Fehlerrate, die Nachbarkanalstörung und die Empfangsfeldstärke zusammen ausgewertet werden. Auch hier sind Lösungen denkbar, die auf einer kombinatorischen Auswertung und einer alternativen beruhen.

Ist gemäß Anspruch 8 keine Aussendung von AM-Zusatzinformationen vorgesehen, so lassen sich die bisher behandelten Kriterien dennoch ausnutzen, um eine Umschaltung des ZF-Filters durchzuführen. Zwar wird dann bei besonders günstigen Empfangsverhältnissen das ZF-Filter auch beim Empfang von Sendern mit normaler Bandbreite auf breit geschaltet, es hat sich jedoch gezeigt, daß dies keine Nachteile mit sich bringt, sondern sogar zu einer Qualitätsverbesserung führen kann, wenn die Bandbreite für normalen Empfang beim Empfänger weiter beschnitten ist, als es durch das Kanalraster an sich erforderlich wäre.

Die Erfindung betrifft ferner eine ZF-Bandbreitenumschaltvorrichtung gemäß den Oberbegriffen der nebengeordneten Ansprüche 9, 10 und 11.

Diesbezüglich liegt ihr die Aufgabe zugrunde, eine ZF-Bandbreitenumschaltvorrichtung dahingehend zu verbessern, daß eine automatische Umschaltung zur Erzielung optimaler Empfangsqualität in Abhängigkeit des Programmangebots sowie der Empfangsverhältnisse ermöglicht wird.

Diese Aufgabe wird durch die jeweils im kennzeichnenden Teil der Ansprüche angegebenen Merkmale gelöst.

Die Kombinationsmöglichkeiten und die damit verbundenen Vorteile entsprechen demjenigen, wie sie im Zusammenhang mit den Verfahrensansprüchen erläutert wurden.

Bei einer praktischen Ausgestaltung eines Nachbarkanalstörungsauswerters handelt es sich um einen auf die Kanalrasterfrequenz abgestimmten Schwingkreis in Verbindung mit einem Gleichrichter. Der Nachbarkanalstörungsauswerters kann sowohl vor dem umschaltbaren ZF-Filter als auch hinter dem umschaltbaren ZF-Filter angeschlossen sein. Ist er hinter dem umschaltbaren ZF-Filter angeordnet, dann erfolgt bei Umschaltung bereits eine Vorselektion des Interferenzsignals, so daß die Arbeitsweise des Auswerters verändert wird. Dies könnte zu einer unerwünscht häufigen Umschaltung zwischen breit und schmal führen. Zur Beseitigung dieser Erscheinung wird deshalb die Auswerte- und Steuerschaltung mit einer Schalthysterese versehen.

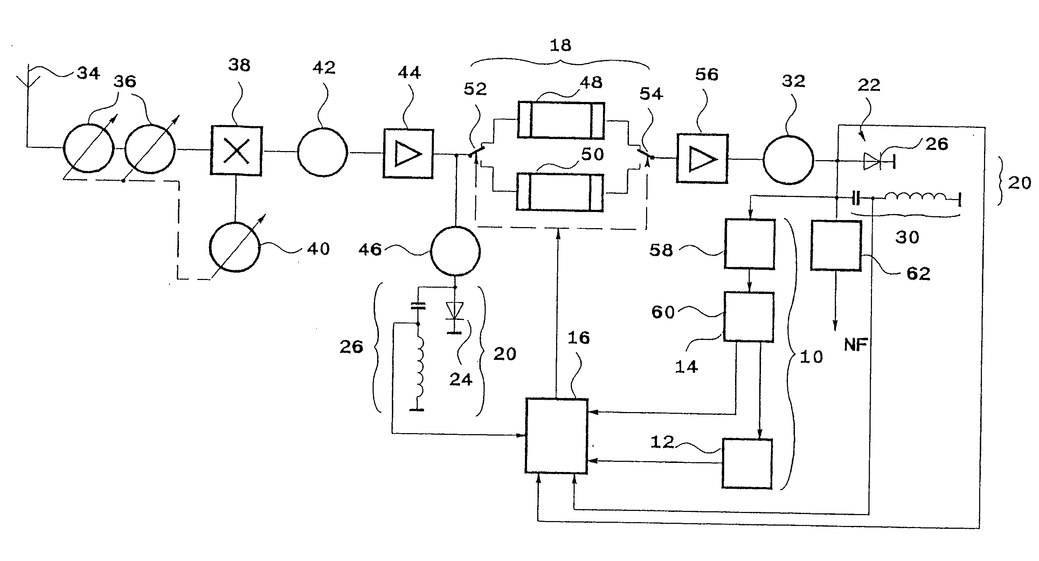

Weiterbildungen und vorteilhafte Ausgestaltungen der Erfindung ergeben sich aus den Ansprüchen, der weiteren Beschreibung und der Zeichnung, die ein Blockschaltbild eines AM-Empfängers mit einer automatischen ZF-Bandbreitenumschaltvorrichtung zeigt.

Aus Vereinfachungsgründen sind in das Schaltbild mehrere Möglichkeiten zur ZF-Bandbreitenumschaltung eingetragen. Dies ist in der Praxis jedoch nicht zwingend erforderlich. Man kann sich auch auf zwei oder nur ein Kriterium beschränken, das für die Umschaltung des ZF-Filters ausgenutzt werden soll.

Zunächst sollen die Baugruppen vorgestellt werden, die in einem konventionellen AM-Empfänger üblich sind.

Empfangssignale gelangen von einer Antenne 34 über Vorkreise 36 zu einer Mischstufe 38, In der zusammen mit der Frequenz eines Oszillators 40 eine Zwischenfrequenz erzeugt wird. Die Vorkreise 36 und der Oszillator 40 sind gemeinsam abstimmbar.

Die dem Mischer 38 entnommenen Signale werden über einen ZF-Vorkreis 42 zu einem ersten ZF-Verstärker 44 geführt und dort verstärkt. Ein ZF-Filter 18 führt eine Hauptselektion des Signals durch und bestimmt maßgeblich durch seine Bandbreite die Bandbreite des später am Ausgang erscheinenden NF-Signals. Dem Filter 18 schließt sich ein zweiter ZF-Verstärker 56 an, dem im Signalweg ein Demodulatorkreis 32 folgt. Am Ausgang des Demodulatorkreises 32 befindet sich ein Gleichrichter 26 und ein Tiefpaßfilter 62, an dessen Ausgang die NF abgreifbar ist. Zur Verringerung von Nachbarkanalstörungen ist zumeist auch ein Schwingkreis 30 vorgesehen, welcher als 9 kHz-Sperre ausgebildet ist.

Durch eine besonders Ausgestaltung des Filters 18 ist der gezeigte AM-Empfänger in der Lage, wahlweise breitbandige oder schmalbandige Programme zu empfangen. Im einzelnen besteht das ZF-Filter 18 aus einem schmalen ZF-Filter 48 und einem breiten ZF-Filter 50. Am Ausgang und am Eingang der beiden Filter befindet sich ein erster Schalter 52 und ein zweiter Schalter 54, die gemeinsam betätigbar sind und entweder das schmale ZF-Filter 48 oder das breite ZF-Filter 50 in den Signalweg einschalten. Die Umschaltung der Schalter 52 und 54 erfolgt jedoch nicht manuell, sondern durch eine Auswerte- und Steuerschaltung 16, wie die Wirkungspfeile andeuten.

Die Auswerte- und Steuerschaltung 16 erhält von verschiedenen Baugruppen Signale. Bei dem beschriebenen Empfängerkonzept ist davon ausgegangen, daß zusätzlich zur AM-Modulation eine AM-Zusatzinformation ausgestrahlt wird. Damit diese AM-Zusatzinformation unhörbar ist, wird zweckmäßig Phasenmodulation angewandt. Zur Demodulation dieser Phasenmodulation dient ein Phasendemodulator 58, der zusammen mit einem Zusatzinformation-Dekoder 60 und einem Bandbreiten-Dekoder 12 eine Baugruppe darstellt, die allgemein zu einem Dekoder 10 zusammengefaßt ist.

Hinter dem Phasendetektor 58 erscheint ein digitaler Datenstrom, in dem bestimmte zusätzliche Informationen unter anderem auch eine Modulationsbandbreiten-Kennung enthalten ist. Die Daten, die in diesem Datenstrom übertragen werden, werden zyklisch wiederholt. Dadurch können auch bei gelegentlichen Störungen die Informationen weitgehend sicher erhalten werden.

Das Datentelegramm enthält zweckmäßig auch Daten zur Verifizierung einer richtigen Übertragung, um eine zuverlässige Auswertung der Daten zu ermöglichen. Aufgrund der Tests dieser Prüfdaten ist es möglich, die Fehlerrate zu bestimmen, was in einem Fehlerratenauswerter 14 erfolgt. Der Fehlerratenauswerter 14 ist in dem Zusatzinformation-Dekoder 60 integriert. Von hier aus führt eine Signalleitung zur Auswerte- und Steuerschaltung 16, die einen der Fehlerrate entsprechenden Signalwert überträgt.

Ein weiterer Ausgang des Zusatzinformation-Dekoders 60 führt zu einem Bandbreiten-Dekoder 12, der die in der AM-Zuatzinformation enthaltene Modulationsbandbreitenkennung auswertet und ein entsprechendes Schaltsignal an die Auswerte- und Steuerschaltung 16 weitergibt.

Mit Hilfe der soweit bechriebenen Baugruppen ist bereits eine automatische Umschaltmöglichkeit des ZF-Filters 18 geschaffen, da die Fehlerrate auch ein Maß für die Störung des Ton-Programms darstellt.

Zusätzlich ist ein Nachbarkanalstörauswerter 20 in die AM-Empfängerschaltung eingebunden. Dieser Nachbarkanalstörauswerter 20 kann sich vor oder hinter dem ZF-Filter 18 befinden. Bei der Ausführung vor dem ZF-Filter 18 gelangt die grob gefilterte ZF über einen Demodulationshilfskreis 46 zum Nachbarkanalstörungsauswerter 20. Dieser umfaßt einen Gleichrichter 24 und einen Serienschwingkreis 26. Der Serienschwingkreis 26 erhält das demodulierte ZF-Signal und ist auf das Kanalraster von 9 kHz soweit sich dies auf Europäische Verhältnisse bezieht, abgestimmt. Von der Mittelanzapfung dieses Schwingkreises 26 führt eine Signalleitung zur Auswerte- und Steuerschaltung 16.

Ergibt sich aufgrund der Ausbreitungsbedingungen beim AM-Empfang etwa ein gleicher Empfangspegel des eingestellten Senders und des im Kanalraster benachbarten Senders, so würde bei der Stellung des ZF-Filters 18 auf "breit" eine Überlagerung der Seitenbänder des empfangenen Senders mit dem Träger des benachbarten Senders oder dessen Seitenbändern stattfinden. Die Folge wären unangenehme Störungen.

Am Gleichrichter 24 tritt in diesem Fall ein 9 kHz Interferenzton auf, der den Serienschwingkreis 26 anregt. Die Amplitude dieses Störsignals wird von der Auswerte - und Steuerschaltung 16 so ausgewertet, daß bei unangenehmer Störung des benachbarten Senders die Bandbreite des ZF-Filters von breit auf schmal umgeschaltet wird.

Als Nachbarkanalstörungsauswerter 20 kann auch die ohnehin vorhandene Kombination des Gleichrichters 26 mit dem Schwingkreis 30 hinter dem ZF-Filter 18 ausgenutzt werden. Da die Amplitude des Störsignals jedoch von der jeweiligen Stellung des ZF-Filters 18 abhängt, ist für diesen Anwendungsfall eine Hysterese vorgesehen, die eine verzögerte Umschaltung des ZF-Filters 18 durch die Auswerte- und Steuerschaltung 16 bewirkt.

Eine dritte Möglichkeit zur Bewertung der Empfangsqualität ist schließlich durch einen Empfangsfeldstärkemesser 22 gegeben, der praktisch durch den ohnehin vorhandenen Gleichrichter 26 gebildet wird. Von hier aus führt also eine Signalleitung zur Auswerte- und Steuerschaltung 16. Diese ist dabei als Mikrorechner ausgebildet und kann die Kriterien alternativ oder auch in Kombination auswerten.

**Patentansprüche**

1. Verfahren zur ZF-Bandbreitenumschaltung in einem AM-Rundfunkempfänger für den Empfang von Sendern unterschiedlicher Modulationsbandbreite, wobei die Sender eine AM-Zusatzinformation ausstrahlen, dadurch gekennzeichnet, daß im AM-Rundfunkempfänger eine in der AM-Zusatzinformation enthaltene Modulationsbandbreiten-Kennung sowie die Fehlerrate der AM-Zusatzinformation ausgewertet werden und daß bei erhöhter Modulationsbandbreite in Verbindung mit einer geringen Fehlerrate eine breite ZF-Bandbreite und bei normaler Modulationsbandbreite oder bei erhöhter Modulationsbandbreite in Verbindung mit einer großen Fehlerrate eine schmale ZF-Bandbreite eingestellt wird.

2. Verfahren zur ZF-Bandbreitenumschaltung in einem AM-Rundfunkempfänger für den Empfang von Sendern unterschiedlicher Modulationsbandbreite, wobei die Sender eine AM-Zusatzinformation ausstrahlen, dadurch gekennzeichnet, daß im AM-Rundfunkempfänger eine in der AM-Zusatzinformation enthaltene Modulationsbandbreiten-Kennung sowie ein Nachbarkanal-Störsignal ausgewertet werden und daß bei erhöhter Modulationsbandbreite in Verbindung mit einer geringen Nachbarkanalstörung eine breite ZF-Bandbreite und bei normaler Modulationsbandbreite oder bei erhöhter Modulationsbandbreite in Verbindung mit einer großen Nachbarkanalstörung eine schmale ZF-Bandbreite eingestellt wird.

3. Verfahren zur ZF-Bandbreitenumschaltung in einem AM-Rundfunkempfänger für den Empfang von Sendern unterschiedlicher Modulationsbandbreite, wobei die Sender eine AM-Zusatzinformation ausstrahlen, dadurch gekennzeichnet, daß im AM-Rundfunkempfänger eine in der AM-Zusatzinformation enthaltene Modulationsbandbreitenkennung sowie die Empfangsfeldstärke ausgewertet werden und daß bei erhöhter Modulationsbandbreite in Verbindung mit einer hohen Empfangsfeldstärke eine breite ZF-Bandbreite und bei normaler Modulationsbandbreite oder bei erhöhter Modulationsbandbreite in Verbindung mit einer kleinen Empfangsfeldstärke eine schmale ZF-Bandbreite eingestellt wird.

4. Verfahren nach Anspruch 1, dadurch gekennzeichnet, daß zusätzlich ein Nachbarkanal-Störsignal ausgewertet wird und daß bei erhöhter Modulationsbandbreite in Verbindung mit einer geringen Fehlerrate und/oder einer geringen Nachbarkanalstörung eine breite ZF-Bandbreite und bei normaler Modulationsbandbreite oder bei erhöhter Modulationsbandbreite in Verbindung mit einer großen Fehlerrate und/oder einer großen Nachbarkanalstörung eine schmale ZF-Bandbreite eingestellt wird.

5. Verfahren nach Anspruch 2, dadurch gekennzeichnet, daß zusätzlich die Empfangsfeldstärke ausgewertet wird und daß bei erhöhter Modulationsbandbreite in Verbindung mit einer geringen Nachbarkanalstörung und/oder einer hohen Empfangsfeldstärke eine breite ZF-Bandbreite und bei normaler Modulationsbandbreite oder bei erhöhter Modulationsbandbreite in Verbindung mit einer großen Nachbarkanalstörung und/oder einer kleinen Empfangsfeldstärke eine schmale ZF-Bandbreite eingestellt wird.

6. Verfahren nach Anspruch 3. dadurch gekennzeichnet, daß zusätzlich die Fehlerrate der AM-Zusatzinformation ausgewertet wird und daß bei erhöhter Modulationsbandbreite in Verbindung mit einer hohen Empfangsfeldstärke und/oder einer geringen Fehlerrate eine breite ZF-Bandbreite und bei normaler Modulationsbandbreite oder bei erhöhter Modulationsbandbreite in Verbindung mit einer kleinen Empfangsfeldstärke und/oder einer großen Fehlerrate eine schmale ZF-Bandbreite eingestellt wird.

7. Verfahren nach Anspruch 4, dadurch gekennzeichnet, daß zusätzlich die Empfangsfeldstärke ausgewertet wird und daß bei erhöhter Modulationsbandbreite in Verbindung mit einer geringen Fehlerrate und/oder einer geringen Nachbarkanalstörung und/oder einer hohen Empfangsfeldstärke eine breite ZF-Bandbreite und bei normaler Modulationsbandbreite oder bei erhöhter Modulationsbandbreite in Verbindung mit einer großen Fehlerrate und/oder einer großen Nachbarkanalstörung und/oder einer kleinen Empfangsfeldstärke eine schmale ZF-Bandbreite eingestellt wird.

8. Verfahren zur ZF-Bandbreitenumschaltung in einem AM-Rundfunkempfänger für den Empfang von Sendern unterschiedlicher Modulationsbandbreite, dadurch gekenn-zeichnet, daß im AM-Rundfunkempfänger ein Nachbarkanal-Störsignal und/oder die Empfangsfeldstärke ausgewertet werden und daß bei einer geringen Nachbarkanalstörung und/oder einer hohen Empfangsfeldstärke eine breite ZF-Bandbreite und bei einer großen Nachbarkanalstörung und/oder einer kleinen Empfangsfeldstärke eine schmale ZF-Bandbreite eingestellt wird.

9. ZF-Bandbreitenumschaltvorrichtung in einem AM-Rundfunkempfänger für den Empfang von Sendern unterschiedlicher Modulationsbandbreite mit einem Dekoder (10) für eine von den Sendern ausgestrahlte AM-Zusatzinformation, dadurch gekennzeichnet, daß ein Bandbreiten-Dekoder (12) zur Auswertung einer in der AM-Zusatzinformation enthaltenen Modulationsbandbreiten-Kennung sowie ein Fehlerratenauswerter (14) für die AM-Zusatzinformation vorgesehen sind und daß der Bandbreiten-Dekoder (12) und der Fehlerratenauswerter (14) mit einer Auswerte- und Steuerschaltung (16) verbunden sind, die ein umschaltbares ZF-Filter (18) bei erhöhter Modulationsbandbreite in Verbindung mit einer geringen Fehlerrate auf "breit" und bei normaler Modulationsbandbreite oder bei erhöhter Modulationsbandbreite in Verbindung mit einer großen Fehlerrate auf "schmal" einstellt.

10. ZF-Bandbreitenumschaltvorrichtung in einem AM-Rundfunkempfänger für den Empfang von Sendern unterschiedlicher Modulationsbandbreite mit einem Dekoder (10) für eine von den Sendern ausgestrahlte AM-Zusatzinformation, dadurch gekennzeichnet, daß ein Bandbreiten-Dekoder (12) zur Auswertung einer in der AM-Zusatzinformation enthaltenen Modulationsbandbreiten-Kennung sowie ein Nachbarkanalstörungsauswerter (20) vorgesehen sind und daß der Bandbreiten-Dekoder (12) und der Nachbarkanalstörungsauswerter (20) mit einer Auswerte- und Steuerschaltung (16) verbunden sind, die ein umschaltbares ZF-Filter (18) bei erhöhter Modulationsbandbreite in Verbindung mit geringen Nachbarkanalstörungen auf "breit" und bei normaler Modulationsbandbreite oder bei erhöhter Modulationsbandbreite in Verbindung mit großen Nachbarkanalstörungen auf "schmal" einstellt.

11. ZF-Bandbreitenumschaltvorrichtung in einem AM-Rundfunkempfänger für den Empfang von Sendern unterschiedlicher Modulationsbandbreite mit einem Dekoder (10) für eine von den Sendern ausgestrahlte AM-Zusatzinformation, dadurch gekennzeichnet, daß ein Bandbreiten-Dekoder (12) zur Auswertung einer in der AM-Zusatzinformation enthaltenen Modulationsbandbreiten-Kennung sowie ein Empfangsfeldstärkemesser (22) vorgesehen sind und daß der Bandbreiten-Dekoder (12) und der Empfangsfeldstärkemesser (22) mit einer Auswerte- und Steuerschaltung (16) verbunden sind, die ein umschaltbares ZF-Filter (18) bei erhöhter Modulationsbandbreite in Verbindung mit großer Empfangsfeldstärke auf "breit" und bei normaler Modulationsbandbreite oder bei erhöhter Modulationsbandbreite in Verbindung mit geringer Empfangsfeldstärke auf schmal" einstellt.

12. ZF-Bandbreitenumschaltvorrichtung nach Anspruch 9, dadurch gekennzeichnet, daß zusätzlich ein Nachbarkanalstörungsauswerter (20) vorgesehen ist und auch dieser mit der Auswerte- und Steuerschaltung (16) verbunden ist, und daß das umschaltbare ZF-Filter (18) durch die Auswerte- und Steuerschaltung (16) bei erhöhter Modulationsbandbreite in Verbindung mit einer geringen Fehlerrate und/oder geringen Nachbarkanalstörungen auf "breit" und bei normaler Modulationsbandbreite oder bei erhöhter Modulationsbandbreite in Verbindung mit einer großen Fehlerrate und/oder großen Nachbarkanalstörungen auf "schmal" einstellbar ist.

13. ZF-Bandbreitenumschaltvorrichtung nach Anspruch 10, dadurch gekennzeichnet, daß zusätzlich ein Empfangsfeldstärkemesser (22) vorgesehen ist und auch dieser mit der Auswerte- und Steuerschaltung (16) verbunden ist, und daß das umschaltbare ZF-Filter (18) durch die Auswerte- und Steuerschaltung (16) bei erhöhter Modulationsbandbreite in Verbindung mit geringen Nachbarkanalstörungen und/oder einer großen Empfangsfeldstärke auf "breit" und bei normaler Moduiationsbandbreite oder bei erhöhter Modulationsbandbreite in Verbindung mit großen Nachbarkanalstörungen und/oder einer geringen Empfangsfeldstärke auf "schmal" einstellbar ist.

14. ZF-Bandbreitenumschaltvorrichtung nach Anspruch 11, dadurch gekennzeichnet, daß zusätzlich ein Fehlerratenauswerter (14) vorgesehen ist und auch dieser mit der Auswerte- und Steuerschaltung (16) verbunden ist, und daß das umschaltbare ZF-Filter (18) durch die Auswerte- und Steuerschaltung (16) bei erhöhter Modulationsbandbreite in Verbindung mit einer großen Empfangsfeldstärke und/oder einer geringen Fehlerrate auf "breit" und bei normaler Modulationsbandbreite oder bei erhöhter Modulationsbandbreite in Verbindung mit einer geringen Empfangsfeldstärke und/oder einer großen Fehlerrate auf "schmal" einstellbar ist.

15. ZF-Bandbreitenumschaltvorrichtung nach Anspruch 12, dadurch gekennzeichnet, daß zusätzlich ein Empfangsfeldstärkemesser (22) vorgesehen ist und auch dieser mit der Auswerte- und Steuerschaltung (16) verbunden ist, und daß das umschaltbare ZF-Filter (18) durch die Auswerte- und Steuerschaltung (16) bei erhöhter Modulationsbandbreite in Verbindung mit einer geringen Fehlerrate und/oder geringen Nachbarkanalstörungen und/oder einer großen Empfangsfeldstärke auf "breit" und bei normaler Modulationsbandbreite oder bei erhöhter Modulationsbandbreite in Verbindung mit einer großen Fehlerrate und/oder großen Nachbarkanalstörungen und/oder einer geringen Empfangsfeldstärke auf "schmal" einstellbar ist

16. ZF-Bandbreitenumschaltvorrichtung nach Anspruch 10, 12, 13 oder 15, dadurch gekennzeichnet, daß der Nachbarkanalstörungsauswerter (20) vor dem umschaltbaren ZF-Filter (18) angeschlossen ist.

17. ZF-Bandbreitenumschaltvorrichtung nach Anspruch 10, 12, 13 oder 15, dadurch gekennzeichnet, daß der Nachbarkanalstörungsauswerter (20) hinter dem umschaltbaren ZF-Filter (18) angeschlossen ist und die Auswerte- und Steuerschaltung (16) eine Schalthysterese aufweist.

18. ZF-Bandbreitenumschaltvorrichtung nach Anspruch 16 oder 17, dadurch gekennzeichnet, daß der Nachbarkanalstörungsauswerter (20) einen Gleichrichter (24, 26) sowie einen auf die Kanalrasterfrequenz abgestimmten Schwingkreis (28, 30) umfaßt.

19. ZF-Bandbreitenumschaltvorrichtung nach Anspruch 18. dadurch gekennzeichnet, daß der Schwingkreis (28, 30) als Serienresonanzkreis ausgebildet ist, an dessen Mittelanzapfung ein Nachbarkanalstörsignal abgreifbar ist.

20. ZF-Bandbreitenumschaltvorrichtung nach Anspruch 11, 13, 14 oder 15, dadurch gekennzeichnet, daß der Empfangsfeldstärkemesser (22) einen hinter einem ZF-Demodulatorkreis (32) angeordneten Gleichrichter (26) umfaßt.

21. ZF-Bandbreitenumschaltvorrichtung nach Anspruch 13, 15 oder 18 bis 20, dadurch gekennzeichnet, daß der Empfangsfeldstärkemesser (22) und der Nachbarkanalstörungsauswerter (20) einen gemeinsamen Gleichrichter (26) umfassen.

22. ZF-Bandbreitenumschaltvorrichtung nach einem oder mehreren der Ansprüche 9 bis 21, dadurch gekennzeichnet, daß die Auswerte- und Steuerschaltung (16) einen Mikrorechner umfaßt.

EP 0 443 170 A2